# EUROPEAN PATENT APPLICATION

(11) **EP 1 659 685 A1**
(43) Date of publication of application: **24.05.2006**
(21) Application number: 05024844.2
(22) Date of filing: 14.11.2005
(51) Int. Cl.: H03D 7/16

(54) **Frequency converter with two stages**

(30) Priority: 17.11.2004 JP 2004333325
(71) Applicant: ALPS ELECTRIC CO., LTD., Tokyo 145-8501 (JP)
(72) Inventor: Sato, Keiichiro, Ota-ku Tokyo, 145-8501 (JP)
(74) Representative: Klunker . Schmitt-Nilson . Hirsch

(57) **Abstract**

A frequency converter for receiving satellite broadcast includes first and second mixers 13 and 16; a plurality of third mixers 14 which selects one of first and second broadcast channel signals respectively output from the first and second mixers 13 and 16, and converts a frequency of the selected broadcast channel signal to a first frequency in a second predetermined band narrower than a first predetermined band; and a plurality of fourth mixers 42 which selects one of the first and second broadcast channel signals respectively output from the first and second mixers 13 and 16, and converts a frequency of the selected broadcast channel signal to a second frequency in the second predetermined band. In the frequency converter, one broadcast channel signal output from the respective third mixers 41 and one broadcast channel signal output from the respective fourth mixers 42 are synthesized corresponding to each other, and the synthesized broadcast channel signal is output from an output port.

## Description

### BACKGROUND OF THE INVENTION

### 1. Field of the Invention

The present invention relates to a frequency converter for receiving satellite broadcast.

### 2. Description of the Related Art

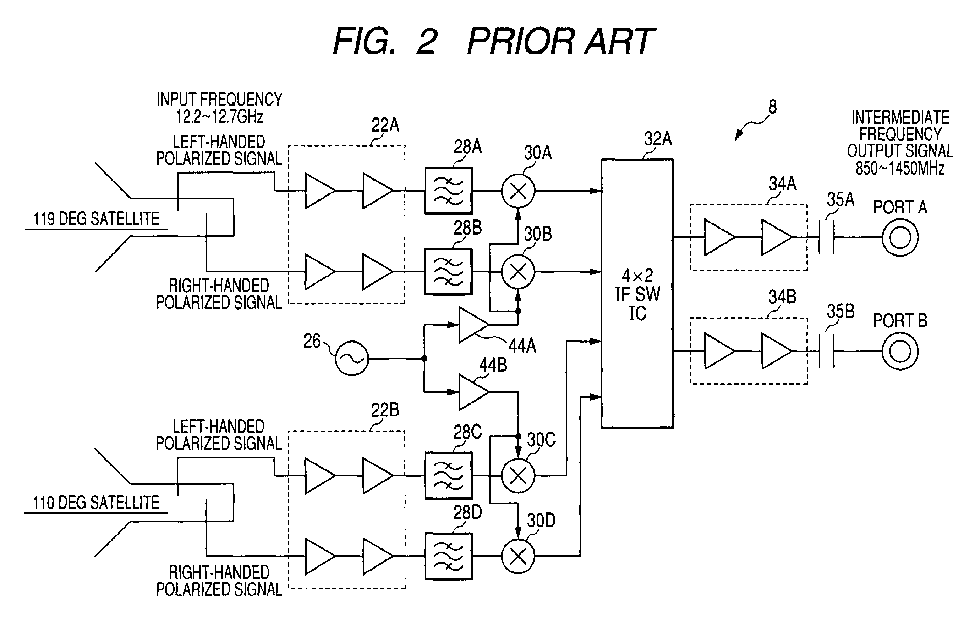

Now, a frequency converter for receiving satellite broadcast (hereinafter, referred to as a LNB (low noise block down converter)) according to a related art will be described with reference to Fig. 2. The LNB 8 includes an LNA (low noise amplifier) 22A that receives a left-handed polarized signal and a right-handed polarized signal (12.2 GHz to 12.7 GHz) transmitted from a 119 DEG satellite and performs low noise amplification on the respective polarized signals; an LNA 22B that receives a left-handed polarized signal and a right-handed polarized signal (12.2 GHz to 12.7 GHz) transmitted from a 110 DEG satellite and performs low noise amplification on the respective polarized signals; BPFs (band pass filters) 28A and 28B that are connected to the LNA 22A and remove image signals from the respective left-handed and right-handed polarized signals on which low noise amplification has been performed; BPFs 28C and 28D that are connected to LNA 22B to remove image signals from the respective left-handed and right-handed polarized signals on which low noise amplification has been performed; a local oscillator 26 that generates a sine wave of 11.25 GHz; and buffer amplifiers 44A and 44B connected to local oscillator 26.

The LNB 8 further includes a mixer 30A that is connected to a BPF 28A and a buffer amplifier 44A and mixes the outputs of the BPF 28A and the buffer amplifier 44A so as to output an IF signal (intermediate frequency signal); a mixer 30B that mixes the outputs of the BPF 28B and the buffer amplifier 44A so as to output an IF signal; a mixer 30C that is connected to a BPF 28C and a buffer amplifier 44B and mixes the outputs of the BPF 28C and the buffer amplifier 44B so as to output an IF signal; and a mixer 30D that mixes the outputs of the BPF 28D and the buffer amplifier 44B so as to output an IF signal. The frequency ranges of the IF signals are 950 MHz to 1450 MHz, and the bandwidth of the IF signals is 500 MHz, which is the same as that of the respective polarized signals.

The LNB 8 further includes a four-by-two IF switch IC (integrated circuit) 32A that is connected to the mixers 30A to 30D, selects IF signals to be output from the mixers 30A to 30D to output the selected IF signals through two output ports; IF amplifiers 34A and 34B that are connected to the two output ports of the four-by-two IF switch IC 32A, respectively; and capacitors 35A and 35B that are respectively connected to the outputs of the IF amplifiers 34A and 34B so as to cut the low frequency noise of the signals output from the IF amplifiers 34A and 34B.

The capacitors 35A and 35B are connected to output ports A and B for the respective IF signals, respectively. Ends of output ports A and B are respectively connected to receivers (set-top boxes, which are not shown). According to the above-mentioned construction, the respective received polarized signals of 1.2 GHz to 12.7 GHz are converted to IF signals of 950 MHz to 1450 MHz in units of groups by the mixers 30A to 30D so as to be output from the respective output ports A and B (for example, see JP-A-2001-168751 (Fig. 3)).

In the frequency converter for receiving satellite broadcast according to the related art, when the IF signals output from the respective output ports are left-handed polarized signals or right-handed polarized signals and any one of the output ports is connected to a plurality of receivers, it may be impossible to receive broadcasts of different polarizing methods at the same time. Further, since the band of IF is wide similarly to the band of the satellite broadcast, it is difficult to operate a local oscillator on the receiver side in order to select an IF signal to be received, in a wide oscillating frequency range.

### SUMMARY OF THE INVENTION

An advantage of the invention is to provide a structure in which, when a plurality of receivers are connected to the same output port, any receiver can receive different types of broadcast channels and in which channel selection can be easily performed.

Therefore, according to an aspect of the invention, a frequency converter for receiving satellite broadcast includes a first mixer that converts a plurality of first broadcast channel signals transmitted from a satellite in a first predetermined band in units of groups; a second mixer that converts a plurality of second broadcast channel signals transmitted from the satellite in the first predetermined band in units of groups; a plurality of third mixers that select one of the first broadcast channel signals output from the first mixer and the second broadcast channel signals output from the second mixer to convert a frequency of the selected broadcast channel signal to a first frequency in a second predetermined band narrower than the first predetermined band; and a plurality of fourth mixers that select one of the first broadcast channel signals output from the first mixer and the second broadcast channel signals output from the second mixer to convert a frequency of the selected broadcast channel signal to a second frequency in the second predetermined band. In the frequency converter, the broadcast channel signals output from the respective third mixers and the broadcast channel signals output from respective fourth mixers are synthesized corresponding to each other, and the synthesized broadcast channel signals are output through a plurality of output ports, respectively.

Further, according to another aspect, the frequency converter further includes a first splitter that is provided on the output side of the first mixer and has a plurality of output ports; a second splitter that is provided on the output side of the second mixer and has a plurality of output ports; and switching units that are provided between pairs of third and fourth mixers and pairs of the output ports of the first splitter and the output ports of the second splitter.

According to the aspect of the invention, the frequency converter includes a plurality of third mixers that select one of the first broadcast channel signals output from the first mixer and the second broadcast channel signals output from the second mixer and then convert the frequency of the selected broadcast channel signal to the first frequency in the second predetermined band narrower than the first predetermined band; and a plurality of fourth mixers that select one of the first broadcast channel signals output from the first mixer and the second broadcast channel signals output from the second mixer and then convert the frequency of the selected broadcast channel signal to the second frequency in the second predetermined band. In the frequency converter, the broadcast channel signals output from the respective third mixers and the broadcast channel signals output from the respective fourth mixers are synthesized corresponding to each other, and the synthesized broadcast channel signals are output through a plurality of output ports, respectively. In the above-mentioned construction, two selected broadcast channel signals are output to each output port and the output broadcast channel signals can be easily received by channel selection of a receiver. Further, since the output broadcast channel signals are arranged within a narrow band, the frequency range of a local oscillating signal supplied to the third and fourth mixers becomes narrower, thereby realizing an oscillator with a simple structure.

Further, according to the another aspect, the frequency converter further includes the first splitter that is provided on the output side of the first mixer and has the plurality of output ports; the second splitter that is provided on the output side of the second mixer and has the plurality of output ports; and the switching units that are provided between pairs of third and fourth mixers, and the pairs which the output ports of the first splitter and the output ports of the second splitter form with a one-to-one relationship. Therefore, it is possible to selectively supply the first broadcast channel signals or the second broadcast channel signals to the first mixer and the second mixer.

### BRIEF DESCRIPTION OF THE DRAWINGS

Fig. 1 is a circuit diagram showing the construction of a frequency converter for receiving satellite broadcast according to the invention; and
Fig. 2 is a circuit diagram showing the construction of a frequency converter for receiving satellite broadcast according to the related art.

### DESCRIPTION OF THE PREFERRED EMBODIMENT

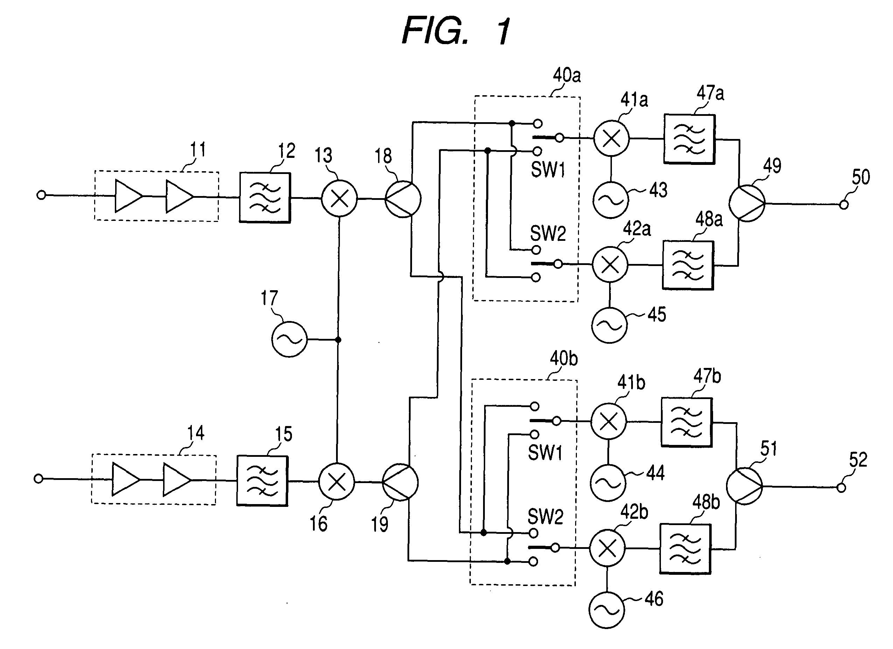

A frequency converter for receiving satellite broadcast according to the invention will now be described with reference to Fig. 1. A plurality of first broadcast channel signals (for example, horizontally polarized signals H) transmitted from a satellite are input to a first mixer 13 via a first low noise amplifier 11 and a first bandpass filter 12. Further, a plurality of second broadcast channel signals (for example, vertically polarized signals V) transmitted from the satellite are input to a second mixer 16 via a second low noise amplifier 14 and a second bandpass filter 15. The first broadcast channel signals and the second broadcast channel signals are arranged within a band of 10.7 GHz to 12.75 GHz.

The first mixer 13 and the second mixer 16 are supplied with a local oscillating signal (having a fixed frequency) from a first oscillator 17. Therefore, the first broadcast channel signals and the second broadcast channel signals are converted into a first predetermined band (for example, 0.5 GHz to 2.55 GHz) in units of groups.

The output side of the first mixer 13 is connected to a first splitter 18 having a plurality of output ports (for example, a one-in, two-out splitter) and the output side of the second mixer 16 is connected to a second splitter 19 having a plurality of output ports (for example, a one-in, two-out splitter). Therefore, the plurality of first broadcast channel signals which are converted in units of groups by the first mixer 13 are output to each output port of the first splitter 18 and the plurality of second broadcast channel signals which are converted in units of groups by the second mixer 16 are output to each output port of the second splitter 19.

One output port of the first splitter 18 and one output port of the second splitter 19 form a pair, and the pair of output ports are connected to a two-by-tow switching unit 40 (40a and 40b). The switching units 40a and 40b have the same construction, and more particularly, each of the switching units 40a and 40b is composed of two one-pole-two-throw switch circuits SW1 and SW2, as shown in Fig. 1.

The output side of each switch circuit SW1 is connected to a third mixer 41 (41a and 41b) and the output side of each switch circuit SW2 is connected to a fourth mixer 42 (42a and 42b). According to this construction, each of the third mixers 41a and 41b is selectively supplied with the first broadcast channel signals converted in units of groups by the first mixer 13 or the second broadcast channel signals converted in units of groups by the second mixer 16. Similarly, each of the fourth mixers 42a and 42b is selectively supplied with the first broadcast channel signals converted in units of groups by the first mixer 13 and the second broadcast channel signals converted in units of groups by the second mixer 16.

The first mixers 41a and 41b are supplied with local oscillating signals from second oscillators 43 and 44, respectively, and the second mixers 42a and 42b are supplied with local oscillating signals from second oscillators 45 and 46, respectively.

Each of the first mixers 41a and 41b selects any one of the first broadcast channel signals and the second broadcast channel signals selected by the switch circuit SW1, and converts a frequency of the selected broadcast channel signal to a first frequency (for example, 1.5 GHz at a center frequency) in a second predetermined band (for example, 1.4 GHz to 1.75 GHz). Further, each of the second mixer 42a and 42b selects any one of the first broadcast channel signals and the second broadcast channel signals selected by the switch circuit SW2, and converts a frequency of the selected broadcast channel signal to a second frequency (for example, 1.65 GHz at a center frequency) in the second predetermined band. As known from the above-mentioned examples, the second predetermined band is narrower than the first predetermined band. For this reason, the oscillating frequency range of each of the second oscillators 43 to 46 may be 1.9 GHz to 4.3 GHz. Therefore, the oscillating frequency range of each of the second oscillators 43 to 46 may be narrow.

One broadcast channel signal output from the respective third mixers 41 and one broadcast channel signal output from the respective fourth mixers 42 pass through bandpass filters 47 (47a and 47b) and 48 (48a and 48b) to be synthesized.

Specifically, one broadcast channel signal output from the third mixer 41a and one broadcast channel signal output from the fourth mixer 42a pass through the bandpass filters 47a and 48a to be synthesized by a first synthesizer 49. The synthesized signal is output to a first output port 50. Further, one broadcast channel signal output from the third mixer 41b and one broadcast channel signal output from the fourth mixer 42b pass through the bandpass filters 47b and 48b to be synthesized by a second synthesizer 51. The synthesized signal is output to a second output port 52.

The output ports 50 and 52 are connected to receivers (not shown), and control signals for switching the respective switch circuits SW1 and SW2 of the switching unit 40 and voltages for controlling the oscillating frequencies of the second oscillators 43 to 46 are supplied to the out ports from the receivers.

## Claims

1. A frequency converter for receiving satellite broadcast comprising:
a first mixer (13) that converts a plurality of first broadcast channel signals transmitted from a satellite in a first predetermined band in units of groups, and
a second mixer (16) that group-converts a plurality of second broadcast channel signals transmitted from the satellite in the first predetermined band in units of groups,
a plurality of third mixers (41; 41a, 41b) that select one of the first broadcast channel signals output from the first mixer (13) and the second broadcast channel signals output from the second mixer (16) to convert a frequency of the selected broadcast channel signal to a first frequency in a second predetermined band narrower than the first predetermined band, and
a plurality of fourth mixers (42; 42a, 42b) that select one of the first broadcast channel signals output from the first mixer (13) and the second broadcast channel signals output from the second mixer (16) to convert a frequency of the selected broadcast channel signal to a second frequency in the second predetermined band,
**characterized in that** the broadcast channel signals output from the respective third mixers (41; 41a, 41b) and the broadcast channel signals output from respective fourth mixers (42; 42a, 42b) are synthesized corresponding to each other, and the synthesized broadcast channel signals are output from a plurality of output ports (50, 52), respectively.

2. The frequency converter for receiving satellite broadcast according to claim 1, further comprising:
a first splitter (18) that is provided on the output side of the first mixer (13) and has a plurality of output ports,
a second splitter (19) that is provided on the output side of the second mixer (16) and has a plurality of output ports, and
switching units (40; 40a, 40b) that are respectively provided between pairs of the third mixers (41; 41a, 41b) and fourth mixers (42; 42a, 42b) and pairs of the output ports of the first splitter (18) and the output ports of the second splitter (19).
